Europäisches Patentamt

European Patent Office

Office européen des brevets

(19)

(11) Veröffentlichungsnummer: **0 001 548 B1**

(12) **EUROPÄISCHE PATENTSCHRIFT**

(21) Anmeldenummer: **78100679.6**

(22) Anmeldetag: **16.08.78**

(51) Int. Cl.³: **H 01 L 25/12**

(54) **Hochleistungsstromrichter mit gekühlten, parallelgeschalteten Stromrichterventilen**

(30) Priorität: **31.08.77 DE 2739242**

(43) Veröffentlichungstag der Anmeldung:
**02.05.79 Patentblatt 79/09**

(45) Bekanntmachung des Hinweises auf die Patenterteilung:
**15.10.80 Patentblatt 80/21**

(84) Benannte Vertragsstaaten:
**DE FR GB SE**

(56) Entgegenhaltungen:
**DE - A - 2 435 459**
**DE - A - 2 515 391**

(73) Patentinhaber: **SIEMENS AKTIENGESELLSCHAFT**
**Berlin und München**
**Postfach 22 02 61**
**D - 8000 München 22 (DE)**

(72) Erfinder: **Bardahl, Nils, Dr.**
**Alb. - Schweitzer - Strasse 15**
**D - 8521 Uttenreuth (DE)**
**Kleisch, Günter**
**Waldstrasse 19**
**D - 8521 Bubenreuth (DE)**

Courier Press, Leamington Spa, England.

Hochleistungsstromrichter mit gekühlten, parallelgeschalteten Stromrichterventilen

Die Erfindung betrifft einen Hochleistungsstromrichter mit einer zwangsgekühlten Stromschiene, auf deren einer Breitseite zwei Reihen von Stromrichterventilen in etwa gleichem Abstand zueinander elektrisch leitend befestigt sind und mit zwei bandförmigen Anschlußstromschienen etwa gleicher Breite, wobei jede Anschlußstromschiene einer Reihe von Stromrichterventilen zugeordnet und jedes Stromrichterventil mit einem Anschluß der zugeordneten Anschlußstromschiene elektrisch leitend verbunden ist und die Anschlüsse etwa den gleichen Abstand zueinander wie die zugeordneten Stromrichterventile aufweisen und wobei beide Anschlußstromschienen in Abstand zueinander und jeweils in einem Winkel zur mit Stromrichterventilen gesetzten Breitseite der zwangsgekühlten Stromrichterschiene angeordnet sind.

Solche Hochleistungsstromrichter mit einer Vielzahl von parallelgeschalteten Stromrichterventilen sind im Handel erhältlich, wobei zumindest die mit Stromrichterventilen besetzte Stromschiene luftgekühlt ist. Bei solchen Hochleistungsstromrichtern mit einer Vielzahl von parallelgeschalteten Stromrichterventilen muß eine möglichst gleichmäßige Belastung aller Stromrichterventile gewährleistet sein, was mit einer gleichmäßigen Stromverteilung über die gesamte Schienenlänge verbunden ist. Aus einem Artikel "Hohe Parallelschaltzahlen in Silizium-Großgleichrichtern", Siemens-Zeitschrift 42 (1968), Seiten 544 bis 549 ist es bekannt, daß neben der Streuung der Durchlaßkennlinien der parallelgeschalteten Stromrichterventile die Stromverteilung von den Längsund Querinduktivitäten des Systems abhängt. Unter Längsinduktivität wird dabei die Induktivität verstanden, die zwischen zwei aufeinanderfolgenden, auf der Stromrichterschiene befestigten Stromrichterventilen auftritt. Die Querinduktivität ist die Induktivität zwischen jedem Stromrichterventil und dem zugehörigen Anschluß auf der Anschlußschiene. Dem Artikel ist zu entnehmen, daß man eine angenähert gleichmäßige Stromverteilung erhält, wenn das Verhältnis von Längs- zu Querinduktivität möglichst klein ist, wobei vorausgesetzt wird, daß die Längsinduktivität zwischen jeweils zwei aufeinanderfolgenden Stromrichterventilen einer mittleren Längsinduktivität entspricht. Messungen an den beschriebenen handelsüblichen Hochleistungsstromrichtern zeigen, daß trotz Beachtung dieser Forderungen starke Abweichungen in der Stromverteilung längs der Stromschienen auftreten, die bis zu 50% vom Mittelwert betragen können.

Es besteht die Aufgabe, einen Hochleistungsstromrichter der eingangs genannten Art in einfacher Weise so auszugestalten, daß eine bessere, gleichmäßige Stromverteilung längs der Stromschienen erhalten wird.

Erfindungsgemäß wird diese Aufgabe dadurch gelöst, daß die beiden bandförmigen Anschlußschienen soweit voneinander entfernt angeordnet sind und ihre Breite so gewählt ist, daß das mit den Außenflächen der Anschlußstromschienen gegebene Viereck in Form und Fläche etwa dem Viereck entspricht, das mit den äußeren Begrenzungen der zwangsgekühlten Stromschiene gegeben ist und daß sich die Anschlüsse an den einander zugewandten Innenflächen der Anschlußstromschienen befinden.

Bei dem erfindungsgemäßen Hochleistungsstromrichter wird in einfacher Weise erreicht, daß die stromaufnehmende und die stromabgebende Stromschiene jeweils die gleiche Querschnittskonfiguration aufweisen, womit einerseits praktisch gleiche Längsinduktivitäten der zwangsgekühlten Stromschiene und der beiden Anschlußstromschienen erhalten werden und andererseits durch Umfangsvergrößerung der von den Anschlußstromschienen bedeckten Flächen die Längsinduktivitäten verkleinert werden. Messungen zeigten, daß damit eine weitgehend gleichmäßige Stromverteilung erhalten wird, die längs der Stromschiene nur noch um wenige Prozent vom Mittelwert abweicht.

Zur Vergrößerung der Querinduktivitäten und damit zur Verkleinerung des obengenannten Verhältnisses können wenigstens in einem Teil der elektrisch leitenden Verbindung zwischen Stromrichterventilen und den zugehörigen Anschlußpunkten Luftdrosseln angeordnet sein. Zweckmäßig ist es, solche Luftdrosseln bei den Stromrichterventilen vorzusehen, die sich in der Nähe der beiden Enden der zwangsgekühlten Stromschiene befinden.

Eine weitere Vergleichmäßigung der Stromverteilung erhält man, wenn die beiden Anschlußstromschienen an ihrem oberen und unteren Ende über Stromausgleichsbügel elektrisch leitend miteinander verbunden sind.

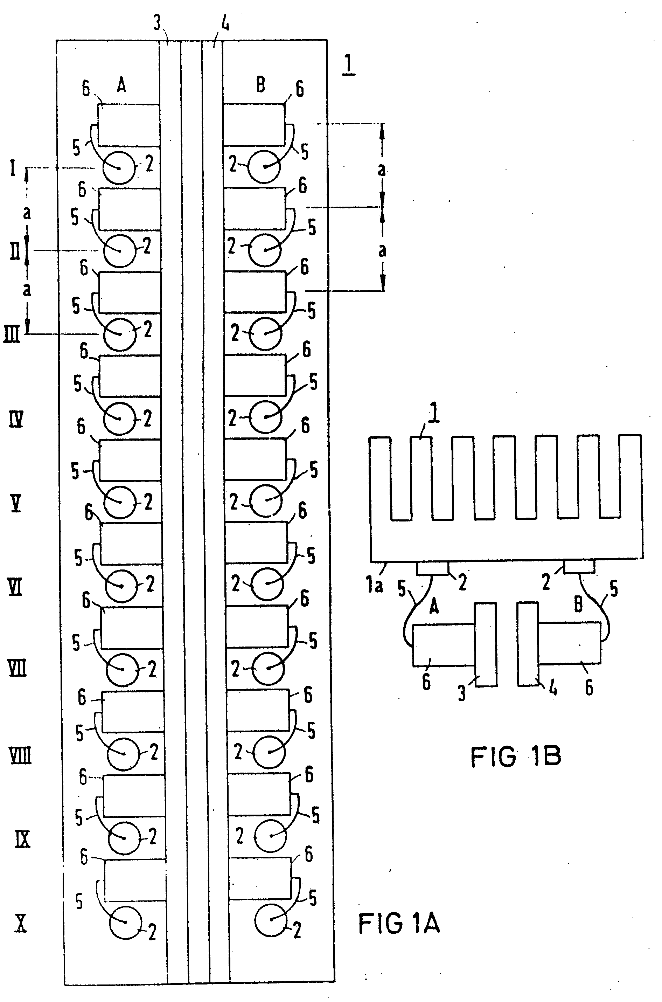

Im folgenden wird der erfindungsgemäße Hochleistungsstromrichter beispielhaft anhand der Figuren 1 bis 3 näher erläutert. Dabei sind in den Figuren gleiche Bauteile mit den gleichen Vorzeichen versehen.

Die Figuren 1A und 1B zeigen einen eingangs beschriebenen, handelsüblichen Hochleistungsstromrichter, wobei die Figur 1A einen Aufriß und die Figur 1B eine Draufsicht zeigen. Auf einer zwangsgekühlten Stromschiene 1, die im Ausführungsbeispiel luftgekühlt ist, sind in zwei mit A und B bezeichneten Reihen jeweils 10 Stromrichterventile 2 angeordnet. Die Stromrichterventile 2 können Dioden oder Thyristoren sein. In jeder Reihe A oder B befinden sich die Stromrichterventile in gleichem Abstand a zueinander. Damit erhält man 10 Etagen von Stromrichterventilen 2, die im Ausführungsbeispiel mit I bis X bezeichnet sind.

Jeder Reihe A oder B von Stromrichterventilen 2 ist eine bandförmige Anschlußstromschiene 3 bzw. 4 zugeordnet. Im Ausführungsbeispiel besitzen die beiden Anschlußstromschienen 3 und 4 etwa gleiche Breite und sind im Abstand zueinander und im rechten Winkel zur Breitseite 1a der zwangsgekühlten Stromschiene 1 angeordnet, auf der die Stromrichterventile 2 elektrisch leitend befestigt sind. Jedes Stromrichterventil 2 der Reihe A und B ist über eine elektrische Leitung 5 mit einem Anschluß 6 der der betreffenden Reihe A oder B zugeordneten Anschlußstromschiene 3 oder 4 verbunden. Beim Ausführungsbeispiel sind die Anschlüsse 6 durch Sicherungen repräsentiert. Diese Ausführungsform wird im allgemeinen eingesetzt, weswegen im folgenden die Anschlüsse der Anschlußschienen 3 und 4 auch mit Sicherungen 6 bezeichnet werden. Auch die Sicherungen 6 befinden sich in gleichem Abstand a wie die Stromrichterventile 2 zueinander.

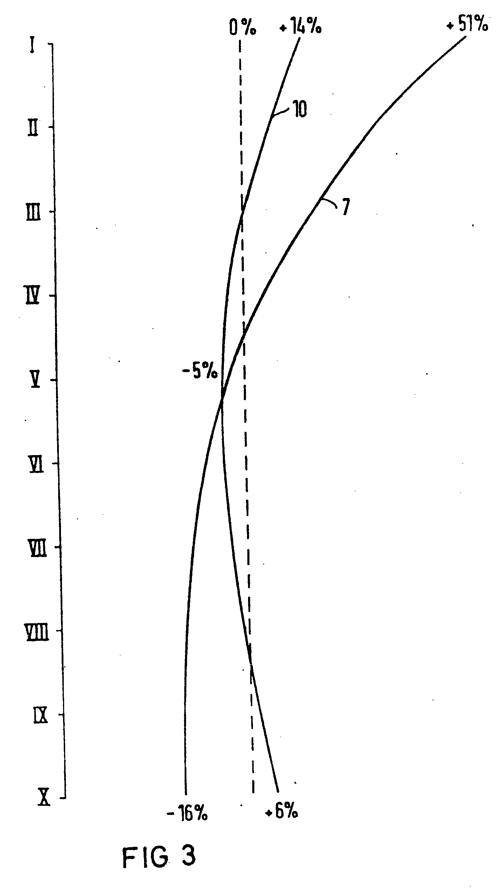

Die Stromverteilung über die Etagen I bis X zeigt die mit 7 bezeichnete Kurve der Figur 3, in der die Schwankungen der Stromverteilung längs der Stromschienen im Vergleich zum Mittelwert aufgezeichnet sind, der mit 0% bezeichnet ist. Die Kurve 7 zeigt, daß die Stromverteilung am einen Ende um + 51% und am anderen Ende um — 16% vom Mittelwert abweicht. Die hieraus resultierende ungleichmäßige Belastung der Stromrichterventile 2 führt entweder zu einer Gefährdung der Stromrichterventile 2 oder dazu, daß der Hochleistungsstromrichter unterhalb der Belastungsgrenze der einzelnen Stromrichterventile 2 betrieben werden muß.

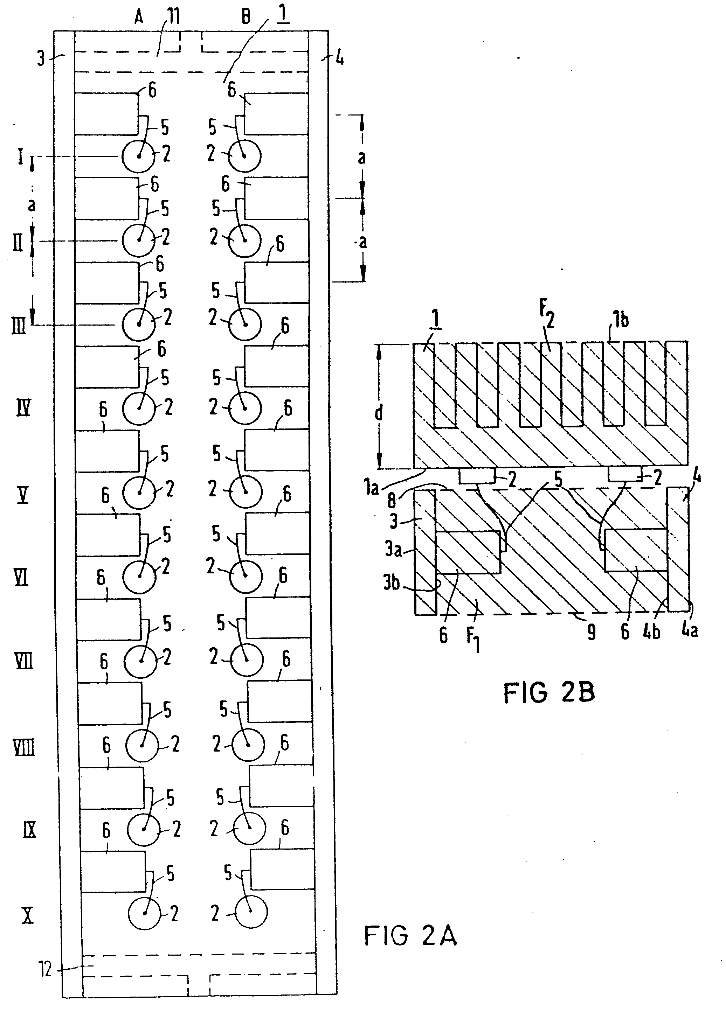

In den Figuren 2A und 2B ist ein erfindungsgemäßer Hochleistungsstromrichter dargestellt. Dabei zeigt die Figur 2A wieder einen Aufriß und die Figur 2B eine Draufsicht.

Von dem im Zusammenhang mit Figur 1A und 1B geschilderten Hochleistungsstromrichter unterscheidet sich der Hochleistungsstromrichter nach Figur 2A und 2B dadurch, daß die Anschlußschienen 3 und 4 mit ihren Außenflächen 3a und 4a etwa bündig mit den Außenflächen der zwangsgekühlten Stromschiene 1 abschließen, daß sich die Sicherungen 6 auf den einander zugewandten Innenflächen 3b und 4b der Anschlußstromschienen 3 und 4 befinden und daß die Anschlußstromschienen 3 und 4 so verbreitert sind, daß ihre Breite etwa mit der Dicke d der zwangsgekühlten Stromschiene 1 übereinstimmt. Durch diese Maßnahmen wird erreicht, daß Form und Fläche des mit $F_1$ bezeichneten Fläche des mit $F_1$ bezeichneten Vierecks, das durch die Außenflächen 3a und 4a und die die Stromschienen verbindenden gestrichelten Linien 8 und 9 gebildet ist, etwa in Form und Fläche mit dem mit $F_2$ bezeichneten Viereck übereinstimmt, das dem Querschnitt entspricht, den die die Kühlfahnen begrenzende, gestrichelte Linie 1b zusammen mit den

Außenseiten der zwangsgekühlten Stromschiene 1 bildet. Die beiden Vierecke $F_1$ und $F_2$ sind in Figur 2B durch Schraffur hervorgehoben.

Durch die Angleichung der Konfiguration der beiden Vierecke $F_1$ und $F_2$ wird, wie bereits geschildert, erreicht, daß die Längsinduktivitäten zwischen den einzelnen Etagen I bis X sowohl des stromaufnehmenden, als auch des stromabgebenden Schienensystems praktisch gleich und gegenüber der herkömmlichen Bauweise verkleinert sind. Damit erhält man eine Stromverteilung gemäß Kurve 10 der Figur 3, die nur noch + 14% und — 5% vom Mittelwert abweicht. Außerdem wird durch diesen Aufbau erreicht, daß an beiden Enden des Stromschienensystems eine Abweichung gleichen Vorzeichens vom Mittelwert vorhanden ist. Mit einer solchen Stromverteilung ist bei sonst gleichen Bauteilen des Stromrichters eine bessere Nennleistung zu erzielen.

Eine weitere Verbesserung der Stromverteilung kann man erreichen, wenn man in die elektrischen Verbindungsleitungen 5 Luftdrosseln einfügt, womit die Querinduktivität erhöht und damit entsprechend den eingangs genannten Forderungen das Verhältnis von Längs- zu Querinduktivität verkleinert wird. Diese Luftdrosseln in Verbindungsleitungen 5 sind im Ausführungsbeispiel nicht eingezeichnet, um die Übersichtlichkeit zu wahren. Zu erwähnen ist jedoch noch, daß diese Luftdrosseln nicht für alle Verbindungsleitungen vorgesehen werden müssen, sondern daß mit einer gezielten Anordnung z.B. in Nähe der Schienenenden die nach Kurve 10 der Figur 3 noch vorhandenen Abweichungen der Stromverteilung ausgeglichen werden können.

In der Figur 2A sind mit gestrichelten Linien außerdem noch Stromausgleichsbügel 11 und 12 eingezeichnet, die am oberen und unteren Ende des Schienensystems die beiden Anschlußstromschienen 3 und 4 elektrisch leitend verbinden. In Figur 2B sind die Stromausgleichsbügel weggelassen, um die Übersichtlichkeit zu wahren. Die Stromverteilung wird beim Einsatz solcher Stromausgleichsbügel 11 und 12 weiter vergleichmäßigt, da mit diesem Ausgleichsbügel eine symmetrische Aufteilung des Stromes auf beide Anschlußschienen 3 und 4 gewährleistet ist.

Es ist noch darauf hinzuweisen, daß zur Erzielung der geschilderten Vorteile es völlig unwichtig ist, ob die Flächen $F_1$ und $F_2$ wie im Ausführungsbeispiel rechteckig sind. Ausschlaggebend ist die Konfiguration der zwangsgekühlten Stromschiene 1, an die durch eine entsprechende Anpassung der Breite der Anschlußschienen 3 und 4, ihres Abstandes und des Winkels, den sie zur Breitseite 1a bilden, die Fläche $F_1$ in Form und Inhalt möglichst genau angepaßt werden muß. Beispielsweise können die Flächen $F_1$ und $F_2$ auch Trapeze, Rauten oder auch unsymmetrische Vierecke sein.

## Patentansprüche

1. Hochleistungsstromrichter mit einer zwangsgekühlten Stromschiene, auf deren einer Breitseite zwei Reihen von Stromrichterventilen in etwa gleichem Abstand zueinander elektrisch leitend befestigt sind, und mit zwei bandförmigen Anschlußstromschienen, wobei jede Anschlußstromschiene einer Reihe von Stromrichterventilen zugeordnet und jedes Stromrichterventil mit einem Anschluß der zugeordneten Anschlußstromschiene elektrisch leitend verbunden ist und die Anschlüsse zueinander etwa den gleichen Abstand wie die zugeordneten Stromrichterventile aufweisen, und wobei beide Anschlußstromschienen in Abstand zueinander und jeweils in einem Winkel zur mit Stromrichterventilen besetzten Breitseite der zwangsgekühlten Stromschiene angeordnet sind, dadurch gekennzeichnet, daß die beiden bandförmigen Anschlußstromschienen (3, 4) so weit voneinander entfernt angeordnet sind und ihre Breite so ausgewählt ist, daß das mit den Außenflächen (3a, 4a) der Anschlußstromschienen gegebene Vierack (F₁) in Form und Fläche etwa dem Viereck (F₂) entspricht, das mit den äußeren Begrenzungen der zwangsgekühlten Stromschiene (1) gegeben ist und daß sich die Anschlüsse (6) auf den einander zugewandten Innenflächen (3b, 4b) der Anschlußstromschienen befinden.

2. Hochleistungsstromrichter nach Anspruch 1, dadurch gekennzeichnet, daß wenigstens in einem Teil der elektrisch leitenden Verbindungen (5) zwischen Stromrichterventilen (2) und den zugehörigen Anschlüssen (6) Luftdrosseln angeordnet sind.

3. Hochleistungsstromrichter nach einem der Ansprüche 1 bis 2, dadurch gekennzeichnet, daß wenigstens an ihrem oberen und unteren Ende die beiden Anschlußstromschienen (3, 4) über Stromausgleichsbügel (11, 12) elektrisch leitend miteinander verbunden sind.

## Revendications

1. Convertisseur de courant à grande puissance comportant un rail conducteur à refroidissement forcé, sur l'un des côtés larges duquel deux rangées d'éléments redresseurs sont fixées d'une façon électriquement conductrice à une distance approximativement constante, et deux rails conducteurs de raccordement en forme de bandes possédant une largeur approximativement identique, et dans lequel chaque rail conducteur de raccordement est associé à une rangée d'éléments redresseurs, chaque élément redresseur est relié d'une façon électriquement conductrice à un raccord du rail conducteur de raccordement associé, les raccords sont approximativement à la même distance les uns des autres que les éléments redresseurs associés et les deux rails conducteurs de raccordement sont disposés à une certaine distance réciproque et en faisant respectivement un certain angle par rapport au côté large, comportant les éléments redresseurs, du rail conducteur à refroidissement forcé, caractérisé par le fait que les deux rails conducteurs de raccordement (3, 4) en forme de bandes sont disposés en étant écartés l'un de l'autre de telle manière et leur largeur est choisie telle que le quadrilatère (F₁), formé par les surfaces extérieures (3a, 4a) des rails conducteurs de raccordement, correspond du point de vue de sa forme et de son étendue approximativement à celles du quadrilatère (F₂) qui est formé par les limites extérieures du rail conducteur (1) à refroidissement forcé, et que les raccords (6) sont situés sur les surfaces intérieures (3b, 4b), tournées l'une vers l'autre, des rails conducteurs de raccordement.

2. Convertisseur de courant à grande puissance suivant la revendication 1, caractérisé par le fait que des bobines d'arrêt à air sont disposées au moins dans une partie des liaisons électriquement conductrices (5) entre les éléments redresseurs (2) et les raccords associés (6).

3. Convertisseur de courant à grande puissance suivant l'une des revendications 1 ou 2, caractérisé par le fait qu'au moins à leur extrémité supérieure et à leur extrémité inférieure, les deux rails conducteurs de raccordement (3, 4) sont reliés entre eux de façon électriquement conductrice par l'intermédiare d'étriers (11, 12) de compensation de courant.

## Claims

1. High-capacity power converter having a force-cooled conductor rail to whose one broadside are electrically connected two equidistantly spaced rows of power converter valves, and two strip-shaped terminal conductor rails, wherein each terminal conductor rail is assigned to one row of power converter valves and each power converter valve is electrically connected to a terminal of the assigned terminal conductor rail and the terminals have virtually the same distance from one another as the assigned power converter valves, and wherein both terminal conductor rails are spaced apart and each is arranged at an angle to the broadside of the force-cooled conductor rails which is provided with power converter valves, characterised in that the two strip-shaped terminal conductor rails (3, 4) are spaced from one another to such an extent and their breadth is such that the quadrangle (F₁) defined by the outer surfaces (3a, 4a) of the terminal conductor rails approximately corresponds to the quadrangle (F₂) which is defined by the outer limitations of the force-cooled conductor rail (1), in respect of shape and surface, and in that the terminals (6) are arranged on the mutually facing inner surfaces (3b, 4b) of the terminal conductor rails.

2. High-capacity power converter as claimed in Claim 1, characterised in that at least in one part of the electrically conductive connections (5) between power converter valves (2) and the assigned terminals (6) there are arranged air-core chokes.

3. High-capacity power converter as claimed in one of claims 1 to 2, characterised in that the two terminal conductor rails (3, 4) are electrically connected together at least at their upper and lower end via current equalization guards (11, 12).

0 001 548

FIG 1A

FIG 1B

FIG 2A

FIG 2B

FIG 3